# EUROPÄISCHE PATENTANMELDUNG

(11) **EP 1 022 769 A2**
(43) Veröffentlichungstag der Anmeldung: **26.07.2000**
(21) Anmeldenummer: 00200180.8
(22) Anmeldetag: 17.01.2000
(51) Int. Cl.: H01L 21/02

(54) **Keramisches, passives Bauelement**

(30) Priorität: 25.01.1999 DE 19902769
(71) Anmelder: Philips Corporate Intellectual Property GmbH, 52064 Aachen (DE); Koninklijke Philips Electronics N.V., 5621 BA Eindhoven (NL)
(72) Erfinder: Löbl, Hans-Peter, 1, 52064 Aachen (DE); Raasch, Detlef, 1, 52064 Aachen (DE); Bentin, Horst, 1, 52064 Aachen (DE); Much, Gerd, 1, 52064 Aachen (DE); Bachmann, Peter Klaus, 1, 52064 Aachen (DE); Klee, Mareike, 1, 52064 Aachen (DE)
(74) Vertreter: Volmer, Georg, Dipl.-Ing.

(57) **Zusammenfassung**

Die Erfindung beschreibt ein keramisches, passives Bauelement mit einem Trägersubstrat (1), wenigstens einer ersten Elektrode (3), wenigstens einer ersten Barriereschicht (4), wenigstens einem Dielektrikum (5) und wenigstens einer zweiten Elektrode (7). Als Barriereschicht (4) wird ein Metall, eine Legierung oder ein leitendes Oxid verwendet.

## Beschreibung

Die Erfindung betrifft ein keramisches, passives Bauelement mit einem Trägersubstrat, wenigstens einer ersten Elektrode, wenigstens einer ersten Barriereschicht, wenigstens einem Dielektrikum und wenigstens einer zweiten Elektrode.

Dünnschichtkondensatoren weisen üblicherweise ein Trägersubstrat, ein Dielektrikum und zwei Elektroden auf. Dabei kann als Trägersubstrat Silicium mit einer Passivierungsschicht, ein keramisches Material, ein glaskeramisches Material oder ein Glasmaterial verwendet werden. Die Elektroden eines Dünnschichtkondensators können aus Edelmetallen oder Nichtedelmetallen sein. Als Materialien für das Dielektrikum kommen nur gut isolierende Werkstoffe wie zum Beispiel Keramiken oder mit Dünnschichtverfahren hergestellte isolierende Schichten in Frage.

Im Verlauf der Herstellung von Dünnschichtkondensatoren werden die Bauelemente Temperaturen von 200 bis 600 °C ausgesetzt. Diese hohen Temperaturen sind notwenig, um eine ausreichende Haftung der einzelnen Schichten der Dünnschichtkondensatoren aufeinander und besonders der untersten Schicht auf dem Trägersubstrat bzw. gegebenfalls der Passivierungsschicht zugewährleisten. Ferner sind diese Temperaturen nötig, um die elektrische Qualität des Dielektrikums zu verbessern.

Durch unterschiedliche thermische Ausdehnungskoeffizienten der einzelnen Schichten kann es bei diesen hohen Temperaturen zu Rißbildungen im Dielektrikum kommen. In diese Hohlräume können Metallatome der Elektroden diffundieren und im Extremfall einen Kurzschluß der beiden Elektroden im Dünnschichtkondensator herbeiführen. Aber auch ohne Rißbildung kann es bei den erhöhten Herstellungstemperaturen zu Diffusion von Metallatomen der Elektroden ins Dielektrikum und damit zu Kurzschlüssen kommen.

Um dieses Problem zu umgehen, kann zwischen dem Dielektrikum und einer Elektrode eine sogenannte Barriereschicht aufgebracht werden. Aus US 3 596 370 ist ein Dünnschichtkondensator bekannt, in dem zwischen der unteren Elektrode und dem Dielektrikum eine Barriereschicht aus Aluminiumoxid oder Aluminiumchromat aufgebracht ist.

Der Nachteil des beschriebenen Dünnschichtkondensators liegt darin, daß einerseits Aluminiumchromat giftig und daß andererseits Aluminiumoxid ein sehr oberflächenrauhes Material ist, welches unerwünschte Reaktionen mit dem Dielektrikum eingehen kann. Außerdem ist Aluminiumoxid selber ein Dielektrikum mir einem εᵣ-Wert, so daß in diesem Dünnschichtkondensator ein Stapel an Dielektrika vorliegt, der die Eigenschaften des Dünnschichtkondensators beeinflußen kann.

Der Erfindung liegt die Aufgabe zugrunde, einen verbesserten Dünnschichtkondensator zu entwickeln.

Diese Aufgabe wird durch ein keramisches, passives Bauelement mit einem Trägersubstrat, wenigstens einer ersten Elektrode, wenigstens einer ersten Barriereschicht, wenigstens einem Dielektrikum und wenigstens einer zweiten Elektrode, dadurch gelöst, daß die Barriereschicht TiₓW_{y} (0 ≤ x ≤ 1, 0 ≤ y ≤ 1),
Cr,
CrₓO_{y} (0 ≤ x ≤ 1, 0 ≤ y ≤ 1),
Nb,
Ta,
Ti,
W,
NiₓMo_{y} (0 ≤ x ≤ 1, 0 ≤ y ≤ 1),
IrₓTa_{y} (0 ≤ x ≤ 1, 0 ≤ y ≤ 1),
IrₓZr_{y} (0 ≤ x ≤ 1, 0 ≤ y ≤ 1),
FeₓW_{y} (0 ≤ x ≤ 1, 0 ≤ y ≤ 1),
NiₓNb_{y} (0 ≤ x ≤ 1, 0 ≤ y ≤ 1),
WₓSi_{y} (0 ≤ x ≤ 1, 0 ≤ y ≤ 1),
PtₓSi_{y} (0 ≤ x ≤ 1, 0 ≤ y ≤ 1),
TaₓSi_{y}N_{z} (0 ≤ x ≤ 1, 0 ≤ y ≤ 1, 0 ≤ z ≤ 1),
TiₓSi_{y}N_{z} (0 ≤ x ≤ 1, 0 ≤ y ≤ 1,0 ≤ z ≤ 1),
MoₓSi_{y}N_{z} (0 ≤ x ≤ 1, 0 ≤ y ≤ 1,0 ≤ z ≤ 1),
CoₓSi_{y} (0 ≤ x ≤ 1, 0 ≤ y ≤ 1),
CrₓSi_{y} (0 ≤ x ≤ 1, 0 ≤ y ≤ 1),
CrₓSi_{y}N_{z} (0 ≤ x ≤ 1, 0 ≤ y ≤ 1),
CrₓSi_{y}O_{z} (0 ≤ x ≤ 1, 0 ≤ y ≤ 1,0 ≤ z ≤ 1),
TiₓN_{y} (0 ≤ x ≤ 1, 0 ≤ y ≤ 1),
WₓN_{y} (0 ≤ x ≤ 1, 0 ≤ y ≤ 1),
TiₓW_{y}N_{z} (0 ≤ x ≤ 1, 0 ≤ y ≤ 1,0 ≤ z ≤ 1),
HfₓN_{y} (0 ≤ x ≤ 1, 0 ≤ y ≤ 1),
TaₓN_{y} (0 ≤ x ≤ 1, 0 ≤ y ≤ 1),
RuₓO_{y} (0 ≤ x ≤ 1, 0 ≤ y ≤ 1),
MoₓO_{y} (0 ≤ x ≤ 1, 0 ≤ y ≤ 1),
IrₓO_{y} (0 ≤ x ≤ 1, 0 ≤ y ≤ 1),
NiₓCr_{y}Al_{z} (0 ≤ x ≤ 1, 0 ≤ y ≤ 1,0 ≤ z ≤ 1) oder Kombinationen dieser Materialien enthält.

Dieser Dünnschichtkondensator hat den Vorteil, daß die Barriereschicht ein Material ohne störende dielektrische Eigenschaften enthält.

In einer bevorzugten Ausführung ist zwischen Dielektrikum und der zweiten Elektrode eine weitere Barriereschicht aus TiₓW_{y} (0 ≤ x ≤ 1, 0 ≤ y ≤ 1),
Cr,
CrₓO_{y} (0 ≤ x ≤ 1, 0 ≤ y ≤ 1),
Nb,
Ta,
Ti,
W,
NiₓNb_{y} (0 ≤ x ≤ 1, 0 ≤ y ≤ 1),
NiₓMo_{y} (0 ≤ x ≤ 1, 0 ≤ y ≤ 1),
IrₓTa_{y} (0 ≤ x ≤ 1, 0 ≤ y ≤ 1),
IrₓZr_{y} (0 ≤ x ≤ 1, 0 ≤ y≤ 1),
FeₓW_{y} (0 ≤ x ≤ 1, 0 ≤ y ≤ 1),
WₓSi_{y} (0 ≤ x ≤ 1, 0 ≤ y ≤ 1),
PtₓSi_{y} (0 ≤ x ≤ 1, 0 ≤ y ≤ 1),
TaₓSi_{y}N_{z} (0 ≤ x ≤ 1, 0 ≤ y ≤ 1,0 $le$$ z ≤ 1),
TiₓSi_{y}N_{z} (0 ≤ x ≤ 1, 0 ≤ y ≤ 1,0 ≤ z ≤ 1),
MoₓSi_{y}N_{z} (0 ≤ x ≤ 1, 0 ≤ y ≤ 1,0 ≤ z ≤ 1),
CoₓSi_{y} (0 ≤ x ≤ 1, 0 ≤ y ≤ 1),
CrₓSi_{y} (0 ≤ x ≤ 1, 0 ≤ y ≤ 1),
CrₓSi_{y}N_{z} (0 ≤ x ≤ 1, 0 ≤ y ≤ 1),
CrₓSi_{y}O_{z} (0 ≤ x ≤ 1, 0 ≤ y ≤ 1,0 ≤ z ≤ 1),
TiₓN_{y} (0 ≤ x ≤ 1, 0 ≤ y ≤ 1),
WₓN_{y} (0 ≤ x ≤ 1, 0 ≤ y ≤ 1),
TiₓW_{y}N_{z} (0 ≤ x ≤ 1, 0 ≤ y ≤ 1,0 ≤ z ≤ 1),
HfₓN_{y} (0 ≤ x ≤ 1, 0 ≤ y ≤ 1),
TaₓN_{y} (0 ≤ x ≤ 1, 0 ≤ y ≤ 1),
RuₓO_{y} (0 ≤ x ≤ 1, 0 ≤ y ≤ 1),
MoₓO_{y} (0 ≤ x ≤ 1, 0 ≤ y ≤ 1),
IrₓO_{y} (0 ≤ x ≤ 1, 0 ≤ y ≤ 1),
NiₓCr_{y}Al_{z} (0 ≤ x ≤ 1, 0 ≤ y ≤ 1,0 ≤ z ≤ 1) oder Kombinationen dieser Materialien vorgesehen- Diese Barriereschicht verhindert unerwünschte Reaktionen zwischen dem Dielektrikum und der zweiten Elektrode. Außerdem besitzen diese Materialien keine dielektrischen Eigenschaften, die die Eigenschaften des Dünnschichtkondensators beeinflussen.

Es kann weiterhin bevorzugt sein, daß zwischen Trigersubstrat und der ersten Elektrode eine Haftschicht aus Ti, Cr, NiₓCr_{y} (0 ≤ x ≤ 1,) oder TiₓW_{y} (0 ≤ x ≤ 1, 0 ≤ y ≤ 1) aufgebracht ist. Diese Haftschicht verbessert die Haftung zwischen dem Trägersubstrat und der ersten Elektrode.

Es ist auch von Vorteil, daß wenigstens eine erste und zweite Stromzuführung an gegeniiberliegenden Seiten des Bauelementes vorgesehen ist. An den Stromzuführungen kann jeder Dünnschichtkondensator mit weiteren Bauelementen eines Schaltkreises elektrisch gekoppelt werden. Je nach Art der Applikation oder Art der Bauteilmontage können als Stromzuführung ein galvanischer SMD-Endkontakt, ein Bump-end-Kontakt oder ein Vias eingesetzt werden. Durch die Verwendung von SMD-Endkontakten oder Bump-end-Kontakten können diskrete Dünnschichtkondensatoren hergestellt werden, während der Einsatz von Vias die direkte Integration des Bauelementes in IC's ermöglicht.

Es ist bevorzugt, daß als Trägersubstrat ein keramisches Material, ein glaskeramisches Material, ein Glasmaterial oder Silicium verwendet wird. Ein Trägersubstrat aus einem keramischen oder glaskeramischen Material oder aus einem Glassubstrat ist kostengünstig herzustellen und die Prozeßkosten für diese Komponente können niedrig gehalten werden. Bei Integration der Mehrkomponenten-Bauteile in IC's ist das Trägersubstrat aus Silicium.

Es ist bevorzugt, daß das Dielektrikum Si₃N₄,
Ta₂O₅,
SiO₂,
SiₓN_{y}O_{z} (0 ≤ x ≤ 1, 0 ≤ y ≤ 1, 0 ≤ z ≤ 1),
SiO₂/Si₃N₄/SiO₂,
Ba₁₋ₓSrₓTiO₃ (0 ≤ x ≤ 1),
SrTi_{1₋x}ZrₓO₃ (0 ≤ x ≤ 1) mit und ohne Mn-Dotierungen,
BaO-Ln₂O₃-TiO₂ (Ln = La. Ce, Nd, Sm oder Eu)
Al₂O₃,
Ba₂Ti₉O₂₀,
Ba₂Ti₉₋ₓZrₓO₂₀ (0 ≤ x ≤ 1) mit und ohne Mn-Dotierungen,
BaTi₅O₁₁,
BaTi₄O₉,
Nb₂O₅,
TiO₂,
(Ta₂O₅)ₓ-(Al₂O₃)₁₋ₓ (0 ≤ x ≤ 1),
(Ta₂O₅)ₓ-(TiO₂)₁₋ₓ (0 ≤ x ≤ 1),
(Ta₂O₅)ₓ-(Nb₂O₅)₁₋ₓ (0 ≤ x ≤ 1),
(Ta₂O₅)ₓ-(SiO₂)_{1₋x} (0 ≤ x ≤ 1),
(Sr,Ca)(Ti,Zr)O₃,
BaO-SrO-CaO-Nd₂O₃-Gd₂O₃-Nb₂O₃-TiO₂,
CaSm₂Ti₅O₁₄,
Zr(Ti,Sn)O₄,
BaO-PbO-Nd₂O₃-Pr₂O₃-Bi₂O₃-TiO₂,
Ba(Zr,Zn,Ta)O₃,
CaTiO₃-LaAlO₃,
(Bi₃(Ni₂Nb)O₉)_{1₋x} (0 ≤ x ≤ 1),
(Bi₂(ZnNb_{2(1+d)y}O_{3+6y+5yd})ₓ (0 ≤ x ≤ 1, 0.5 ≤ y ≤ 1.5, -0.05 ≤ x ≤ 0.05),
Pb(ZrₓTi_{1₋x})O₃ (x = 0 bis 1) mit und ohne Bleiüberschuß,
Pb_{1₋αy}La_{y}(ZrₓTi_{1₋x})O₃ (0 ≤ x ≤ 1, 0 ≤ y ≤ 0.2, 1.3 ≤ α ≤ 1.5),
Pb_{1₋αy} La_{y}TiO₃ (0 ≤ y ≤ 0.2, 1.3 ≤ α ≤ 1.5),
(Pb,Ca)TiO₃,
BaTiO₃ mit und ohne Dotierungen,
BaZrₓTi_{1₋x}O₃ (0 ≤ x ≤ 1),
Ba_{1₋y}Sr_{y}ZrₓT_{1₋x}O₃ (0 ≤ x ≤ 1, 0 ≤ y ≤ 1),
Ba(Zn,Ta)O₃,
BaZrO₃,
PbNbₓ((Zr_{0.6}Sn_{0.4})_{1₋y}Ti_{y}))_{1₋z}O₃ (0 ≤ x ≤ 0.9, 0 ≤ y ≤ 1),
Pb(Mg_{1/3}Nb_{2/3})O₃]ₓ-[PbTiO₃]_{1₋x} (0 ≤ x ≤ 1),
(Pb,Ba,Sr)(Mg_{1/3}Nb_{2/3})ₓTi_{y}(Zn_{1/3}Nb_{2/3})_{1₋x₋y}O₃ (0 ≤ x ≤ 1, 0 ≤ y ≤ 1, x + y ≤ 1),

a) Pb(Mg_{1/2}W_{1/2})O₃
b) Pb(Fe_{1/2}Nb_{1/2})O₃
c) Pb(Fe_{2/3}W_{1/3})O₃
d) Pb(Ni_{1/3}Nb_{2/3})O₃
e) Pb(Zn_{1/3}Nb_{2/3})O₃
f) Pb(Sc_{1/2}Ta_{1/2})O₃
sowie Kombinationen der Verbindungen a)- f) mit PbTiO₃ und Pb(Mg_{1/3}Nb_{2/3})O₃ mit und ohne Bleiüberschuß enthält.

Es ist weiterhin bevorzugt, daß die Elektroden Al, Al doriert mit Cu, Al doriert mit Si, Al dotiert mit Mg oder Ag, Cu, Ni, Au, W oder Kombinationen dieser Metalle enthalten. Die Schichten werden beispielsweise mittels lithographischer Prozesse verbunden mit Naß- und Trockenätzschritten zu Elektroden strukturiert.

Es kann außerdem bevorzugt sein, daß auf der zweiten Elektrode eine Schutzschicht aus einem organischen und/oder anorganischen Polymer vorgesehen ist. Diese Schutzschicht schützt die darunterliegenden Elektroden und das Dielektrikum beispielsweise vor mechanischer Beanspruchung und Korrosion.

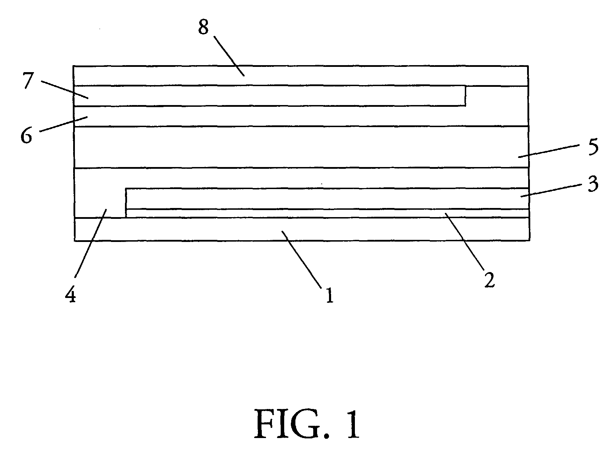

Im folgenden soll die Erfindung anhand einer Figur und zweier Ausführungsbeispiele erläuten werden. Dabei zeigt Fig. 1 im Querschnitt den schematischen Aufbau eines erfindungsgemäßen Dünnschichtkondensators.

Gemäß Fig. 1 weist ein Dünnschichtkondensator ein Trägersubstrat 1 auf, welches zum Beispiel aus einem keramischen Material, einem glaskeramischen Material, einem Glasmaterial oder Silicium ist. Auf dem Trägersubstrat 1 befindet sich eine Haftschicht 2, die zum Beispiel Ti, Cr, NiₓCr_{y} (0 ≤ x ≤ 1, 0 ≤ y ≤ 1) oder TiₓW_{y} (0 ≤ x ≤ 1, 0 ≤ y ≤ 1) enthält, und auf der Haftschicht 2 ist eine erste Elektrode 3 aufgebracht. Die erste Elektrode 3 enthält beispielsweise Al, Al dotiert mir Cu, Al dotiert mit Si, Al doriert mit Mg oder Ag, Cu, Ni, Au, W oder Kombinationen dieser Metalle. Auf dieser ersten Elektrode 3 befindet sich eine Barriereschicht 4, die zum Beispiel
TiₓW_{y} (0 ≤ x ≤ 1, 0 ≤ y ≤ 1),
Cr,
CrₓO_{y} (0 ≤ x ≤ 1, 0 ≤ y ≤ 1),
Nb,
Ta,
Ti,
W,
NiₓNb_{y} (0 ≤ x ≤ 1, 0 ≤ y ≤ 1),
NiₓMo_{y} (0 ≤ x ≤ 1, 0 ≤ y ≤ 1),
IrₓTa_{y}(0 ≤ x ≤ 1, 0 ≤ y ≤ 1),
IrₓZr_{y} (0 ≤ x ≤ 1, 0 ≤ y ≤ 1),
FeₓW_{y} (0 ≤ x ≤ 1, 0 ≤ y ≤ 1),
WₓSi_{y} (0 ≤ x ≤ 1, 0 ≤ y ≤ 1),
PtₓSi_{y} (0 ≤ x ≤ 1, 0 ≤ y ≤ 1),
TaₓSi_{y}N_{z} (0 ≤ x ≤ 1, 0 ≤ y ≤ 1,0 ≤ z ≤ 1),
TiₓSi_{y}N_{z} (0 ≤ x ≤ 1, 0 ≤ y ≤ 1,0 ≤ z ≤ 1),
MoₓSi_{y}N_{z} (0 ≤ x ≤ 1, 0 ≤ y ≤ 1,0 ≤ z ≤ 1),
CoₓSi_{y} (0 ≤ x ≤ 1, 0 ≤ y ≤ 1),
CrₓSi_{y} (0 ≤ x ≤ 1, 0 ≤ y ≤ 1),
CrₓSi_{y}N_{z} (0 ≤ x ≤ 1, 0 ≤ y ≤ 1),
CrₓSi_{y}O_{z} (0 ≤ x ≤ 1, 0 ≤ y ≤ 1,0 ≤ z ≤ 1),
TiₓN_{y} (0 ≤ x ≤ 1, 0 ≤ y ≤ 1),
WₓN_{y} (0 ≤ x ≤ 1, 0 ≤ y ≤ 1),
TiₓW_{y}N_{z} (0 ≤ x ≤ 1, 0 ≤ y ≤ 1,0 ≤ z ≤ 1),
HfₓN_{y} (0 ≤ x ≤ 1, 0 ≤ y ≤ 1),
TaₓN_{y} (0 ≤ x ≤ 1, 0 ≤ y ≤ 1),
RuₓO_{y} (0 ≤ x ≤ 1, 0 ≤ y ≤ 1),
MoₓO_{y} (0 ≤ x ≤ 1, 0 ≤ y ≤ 1),
IrₓO_{y} (0 ≤ x ≤ 1, 0 ≤ y ≤ 1),
NiₓCr_{y}Al_{z} (0 ≤ x ≤ 1, 0 ≤ y ≤ 1,0 ≤ z ≤ 1) oder Kombinationen dieser Materialien enthält.

Ein Dielektrikum 5 beispielsweise aus Si₃N₄,
Ta₂O₅,
SiO₂,
SiₓN_{y}O_{z} (0 ≤ x ≤ 1, 0 ≤ y ≤ 1, 0 ≤ z ≤ 1),
SiO₂/Si₃N₄/ SiO₂,
Ba_{1₋x}SrₓTiO₃ SiO₂
SrTi_{1₋x}ZrₓO₃ (0 ≤ x ≤ 1) mit und ohne Mn-Dotierungen,
BaO-Ln₂O₃-TiO₂ (Ln = La, Ce, Nd, Sm oder Eu)
Al₂O₃,
Ba₂Ti₉O₂₀,
Ba₂Ti_{9₋x}ZrₓO₂₀ (0 ≤ x ≤ 1) mit und ohne Mn-Dotierungen,
BaTi₅O₁₁,
BaTi₄O₉,
Nb₂O₅,
TiO₂,
(Ta₂O₅)ₓ-(Al₂O₃)_{1₋x} (0 ≤ x ≤ 1),
(Ta₂O₅)ₓ-(TiO₂)_{1₋x} (0 ≤ x ≤ 1),
(Ta₂O₅)ₓ-(Nb₂O₅)_{1₋x} (0 ≤ x ≤ 1),
(Ta₂O₅)ₓ-(SiO₂)_{1₋x} (0 ≤ x ≤ 1),
(Sr,Ca)(Ti,Zr)O₃,
BaO-SrO-Nd₂O₃-Gd₂O₃-Nb₂O₃-TiO₂,
CaSm₂Ti₅O₁₄,
Zr(Ti,Sn)O₄,
BaO-PbO-CaO-Nd₂O₃-Pr₂O₃-Bi₂O₃-TiO₂,
Ba(Zr,Zn,Ta)O₃,
CaTiO₃-LaAlO₃,
(Bi₃(Ni₂Nb)O₉)_{1₋x} (0 ≤ x ≤ 1),
(Bi₂(ZnNb_{2(1+d)y}O_{3+6y+5yd})ₓ (0 ≤ x ≤ 1, 0.5 ≤ y ≤ 1.5, -0.05 ≤ x ≤ 0.05),
Pb(ZrₓTi_{1₋x})O₃ (0 ≤ x ≤ 1) mit und ohne Bleiüberschuß,
Pb_{1₋αy}(ZrₓTi_{1₋x})O₃ (0 ≤ x ≤ 1, 0 ≤ y ≤ 0.2, 1.3 ≤ α ≤ 1.5),
Pb_{1₋αy} La_{y}TiO₃ (0 ≤ y ≤ 0.3, 1.3 ≤ α ≤ 1.5),
(Pb,Ca)TiO₃,
BaTiO₃ mit und ohne Dotierungen,
BaZrₓTi₁₋ₓO₃ (0 ≤ x ≤ 1),
Ba_{1₋y}Sr_{y}ZrₓTi_{1₋x}O₃ (0 ≤ x ≤ 1, 0 ≤ y ≤ 1),
Ba(Zn,Ta)O₃,
BaZrO₃,
PbNbₓ((Zr_{0.6}Sn_{0.4})_{1₋y}Ti_{y})_{1₋x}O₃ (0 ≤ x ≤ 0.9, 0 ≤ y ≤ 1),
Pb(Mg_{1/3}Nb_{2/3})O₃]ₓ-[PbTiO₃]_{1₋x} (0 ≤ x ≤ 1),
(Pb,Ba,Sr)(Mg_{1/3}Nb_{2/3})ₓTi_{y}Zn_{1/3}Nb_{2/3})_{1₋x₋y}O₃ (0 ≤ x ≤ 1, 0 ≤ y ≤ 1, x + y ≤ 1),

a) Pb(Mg_{1/2}W_{1/2})O₃
b) Pb(Fe_{1/2}Nb_{1/2})O₃
c) Pb(Fe_{2/3} W_{1/3})O₃
d) Pb(Ni_{1/3}Nb_{2/3})O₃
e) Pb(Zn_{1/3}Nb_{2/3})O₃
f) Pb(Sc_{1/2}Ta_{1/2})O₃
sowie Kombinationen der Verbindungen a)-f) mit PbTiO₃ und Pb(Mg_{1/3}Nb_{2/3})O₃ mit und ohne Bleiüberschuß wurde auf dieser Barriereschicht 4 aufgebracht. Auf dem Dielektrikum 5 befindet sich eine weitere Barriereschicht 6 welche beispielsweise
TiₓW_{y} (0 ≤ x ≤ 1, 0 ≤ y ≤ 1),
Cr,
CrₓO_{y} (0 ≤ x ≤ 1, 0 ≤ y ≤ 1),
Nb,
Ta,
Ti,
W,
NiₓNb_{y} (0 ≤ x ≤ 1, 0 ≤ y ≤ 1),
NiₓMo_{y} (0 ≤ x ≤ 1, 0 ≤ y ≤ 1),
IrₓTa_{y} (0 ≤ x ≤ 1, 0 ≤ y ≤ 1),
IrₓZr_{y} (0 ≤ x ≤ 1, 0 ≤ y ≤ 1),
FeₓW_{y} (0 ≤ x ≤ 1, 0 ≤ y ≤ 1),
WₓSi_{y} (0 ≤ x ≤ 1, 0 ≤ y ≤ 1),
PtₓSi_{y} (0 ≤ x ≤ 1, 0 ≤ y ≤ 1),
TaₓSi_{y}N_{z} (0 ≤ x ≤ 1, 0 ≤ y ≤ 1,0 ≤ z ≤ 1),
TiₓSi_{y}N_{z} (0 ≤ x ≤ 1, 0 ≤ y ≤ 1,0≤ z ≤ 1),
MoₓSi_{y}N_{z} (0 ≤ x ≤ 1, 0 ≤ y ≤ 1,0 ≤ z ≤ 1),
CoₓSi_{y} (0 ≤ x ≤ 1, 0 ≤ y ≤ 1),
CrₓSi_{y} (0 ≤ x ≤ 1, 0 ≤ y ≤ 1),
CrₓSi_{y}N_{z} (0 ≤ x ≤ 1, 0 ≤ y ≤ 1),
CrₓSi_{y}O_{z} (0 ≤ x ≤ 1, 0 ≤ y ≤ 1, 0 ≤ z ≤ 1),
TiₓN_{y} (0 ≤ x ≤ 1, 0 ≤ y ≤ 1),
WₓN_{y} (0 ≤ x ≤ 1, 0 ≤ y ≤ 1),
TiₓW_{y}N_{z} (0 ≤ x ≤ 1, 0 ≤ y ≤ 1,0 ≤ z ≤ 1),
HfₓN_{y} (0 ≤ x ≤ 1, 0 ≤ y ≤ 1),
TaₓN_{y} (0 ≤ x ≤ 1, 0 ≤ y ≤ 1),
RuₓO_{y} (0 ≤ x ≤ 1, 0 ≤ y ≤ 1),
MoₓO_{y} (0 ≤ x ≤ 1, 0 ≤ y ≤ 1),
IrₓO_{y} (0 ≤ x ≤ 1, 0 ≤ y ≤ 1),
NiₓCr_{y}Al_{z} (0 ≤ x ≤ 1, 0 ≤ y ≤ 1,0 ≤ z ≤ 1) oder Kombinationen dieser Materialien enthält. Eine zweite Elektrode 7 ist auf der Barriereschicht 6 aufgebracht. Diese zweite Elektrode 7 enthält zum Beispiel Al, Al dotiert mit Cu, Al dotiert mit Si, Al dotiert mit Mg oder Ag, Cu, Ni, Au, W oder Kombinationen dieser Metalle. Über dieser zweiten Elekrrode ist eine Schutzschicht 8 aus einem organischen und/oder anorganischen Polymer aufgebracht. Als organisches Polymer kann beispielsweise Polyimid und als anorganisches Polymer kann zum Beispiel Si₃N₄ verwendet werden.

Alternativ kann auf gegenüberliegenden Seiten des keramischen passiven Bauelementes mindestens eine erste und zweite Stromzuführung angebracht werden. Als Stromzuführung kann ein galvanischer SMD-Endkontakt aus Cr/Ni, Ni/Sn oder Cr/Cu, Cu/Ni/Sn oder einer Pb/Sn-Legierung oder ein Bump-end-Kontakt oder ein Vias eingesetzt werden.

Im folgenden werden Ausführungsformen der Erfindung erläutert, die beispielhafte Realisierungsmöglichkeiren darstellen.

### Ausführungsbeispiel 1:

Auf einem Trägersubstrat 1 aus Glas befindet sich eine Haftschicht 2 aus Cr. Auf diese Haftschicht 2 wird eine erste Elektrode 3 aus Cu abgeschieden. Auf diese untere Elektrode 3 wird eine Barriereschicht 4 aus Ti_{0.1}W_{0.9}, aufgebracht. Über dieser Barriereschicht 4 befinden sich ein Dielektrikum 5 aus Si₃N₄ und eine weitere Barriereschicht 6 aus Ti_{0.1}W_{0.9}. Auf die Barriereschicht 6 ist eine zweite Elektrode 7 aus Cu und über der zweiten Elektrode 7 eine Schutzschicht 8 aus Polyimid aufgebracht.

### Ausführungsbeispiel 2:

Auf einem Trägersubstrat 1 aus Glas befindet sich eine Haftschicht 2 aus Cr. Auf diese Haftschicht 2 wird eine erste Elektrode 3 aus Ni abgeschieden. Auf diese untere Elektrode 3 wird eine Barriereschicht 4 aus Ti_{0.1}W_{0.9} aufgebracht. Über dieser Barriereschicht 4 befinden sich ein Dielektrikum 5 aus SiO₂/Si₃N₄/SiO₂ und eine weitere Barriereschicht 6 aus Ti_{0.1}W_{0.9}. Auf die Barriereschicht 6 isr eine zweite Elektrode 7 aus Ni und über der zweiten Elektrode 7 eine Schutzschicht 8 aus Polyimid aufgebracht.

## Patentansprüche

1. Keramisches, passives Bauelement mit einem Trägersubstrat (1),
wenigstens einer ersten Elektrode (3),
wenigstens einer ersten Barriereschicht (4),
wenigstens einem Dielektrikum (5) und wenigstens einer zweiten Elektrode (7),
dadurch gekennzeichnet,
daß die Barriereschicht (4) TiₓW_{y} (0 ≤ x ≤ 1, 0 ≤ y ≤ 1),
Cr,
CrₓO_{y} (0 ≤ x ≤ 1, 0 ≤ y ≤ 1),
Nb,
Ta,
Ti,
W,
NiₓNb_{y} (0 ≤ x ≤ 1, 0 ≤ y ≤ 1),
NiₓMo_{y} (0 ≤ x ≤ 1, 0 ≤ y ≤ 1),
IrₓTa_{y} (0 ≤ x ≤ 1, 0 ≤ y ≤ 1),
IrₓZr_{y} (0 ≤ x ≤ 1, 0 ≤ y ≤ 1),
FeₓW_{y} (0 ≤ x ≤ 1, 0 ≤ y ≤ 1),
WₓSi_{y} (0 ≤ x ≤ 1, 0 ≤ y ≤ 1),
PtₓSi_{y} (0 ≤ x ≤ 1, 0 ≤ y ≤ 1),
TaₓSi_{y}N_{z} (0 ≤ x ≤ 1, 0 ≤ y ≤ 1,0 ≤ z ≤ 1),
TiₓSi_{y}N_{z} (0 ≤ x ≤ 1, 0 ≤ y ≤ 1,0 ≤ z ≤ 1),
MoₓSi_{y}N_{z} (0 ≤ x ≤ 1, 0 ≤ y ≤ 1,0 ≤ z ≤ 1),
CoₓSi_{y} (0 ≤ x ≤ 1, 0 ≤ y ≤ 1),
CrₓSi_{y} (0 ≤ x ≤ 1, 0 ≤ y ≤ 1),
CrₓSi_{y}N_{z} (0 ≤ x ≤ 1, 0 ≤ y ≤ 1),
CrₓSi_{y}O_{z} (0 ≤ x ≤ 1, 0 ≤ y ≤ 1,0 ≤ z ≤ 1),
TiₓN_{y} (0 ≤ x ≤ 1, 0 ≤ y ≤ 1),
WₓN_{y} (0 ≤ x ≤ 1, 0 ≤ y ≤ 1),
TiₓW_{y}N_{z} (0 ≤ x ≤ 1, 0 ≤ y ≤ 1,0 ≤ z ≤ 1),
HfₓN_{y} (0 ≤ x ≤ 1, 0 ≤ y ≤ 1),
TaₓN_{y} (0 ≤ x ≤ 1, 0 ≤ y ≤ 1),
RuₓO_{y} (0 ≤ x ≤ 1, 0 ≤ y ≤ 1),
MoₓO_{y} (0 ≤ x ≤ 1, 0 ≤ y ≤ 1),
IrₓO_{y} (0 ≤ x ≤ 1, 0 ≤ y ≤ 1),
NiₓCr_{y}Al_{z} (0 ≤ x ≤ 1, 0 ≤ y ≤ 1,0 ≤ z ≤ 1) oder Kombinationen dieser Materialien enthält.

2. Keramisches, passives Bauelement nach Anspruch 1,
dadurch gekennzeichnet,
daß zwischen Dielektrikum (5) und der zweiten Elektrode (7) eine weitere Barriereschicht (6) ausTiₓW_{y} (0 ≤ x ≤ 1, 0 ≤ y ≤ 1),
Cr,
CrₓO_{y} (0 ≤ x ≤ 1, 0 ≤ y ≤ 1),
Nb,
Ta,
Ti,
W,
NiₓMo_{y} (0 ≤ x ≤ 1, 0 ≤ y ≤ 1),
IrₓTa_{y} (0 ≤ x ≤ 1, 0 ≤ y ≤ 1),
IrₓZr_{y} (0 ≤ x ≤ 1, 0 ≤ y ≤ 1),
FeₓW_{y} (0 ≤ x ≤ 1, 0 ≤ y ≤ 1),
NiₓNb_{y} (0 ≤ x ≤ 1, 0 ≤ y ≤ 1),
WₓSi_{y} (0 ≤ x ≤ 1, 0 ≤ y ≤ 1),
PtₓSi_{y} (0 ≤ x ≤ 1, 0 ≤ y ≤ 1),
TaₓSi_{y}N_{z} (0 ≤ x ≤ 1, 0 ≤ y ≤ 1,0 ≤ z ≤ 1),
TiₓSi_{y}N_{z} (0 ≤ x ≤ 1, 0 ≤ y ≤ 1,0 ≤ z ≤ 1),
MoₓSi_{y}N_{z} (0 ≤ x ≤ 1, 0 ≤ y ≤ 1,0 ≤ z ≤ 1),
CoₓSi_{y} (0 ≤ x ≤ 1, 0 ≤ y ≤ 1),
CrₓSi_{y} (0 ≤ x ≤ 1, 0 ≤ y ≤ 1),
CrₓSi_{y}N_{z} (0 ≤ x ≤ 1, 0 ≤ y ≤ 1),
CrₓSi_{y}O_{z} (0 ≤ x ≤ 1, 0 ≤ y ≤ 1,0 ≤ z ≤ 1),
TiₓN_{y} (0 ≤ x ≤ 1, 0 ≤ y ≤ 1),
WₓN_{y} (0 ≤ x ≤ 1, 0 ≤ y ≤ 1),
TiₓW_{y}N_{z} (0 ≤ x ≤ 1, 0 ≤ y ≤ 1,0 ≤ z ≤ 1),
HfₓN_{y} (0 ≤ x ≤ 1, 0 ≤ y ≤ 1),
TaₓN_{y} (0 ≤ x ≤ 1, 0 ≤ y ≤ 1),
RuₓO_{y} (0 ≤ x ≤ 1, 0 ≤ y ≤ 1),
MoₓO_{y} (0 ≤ x ≤ 1, 0 ≤ y ≤ 1),
IrₓO_{y} (0 ≤ x ≤ 1, 0 ≤ y ≤ 1),
NiₓCr_{y}Al_{z} (0 ≤ x ≤ 1, 0 ≤ y ≤ 1,0 ≤ z ≤ 1) oder Kombinationen dieser Materialien vorgesehen ist.

3. Keramisches, passives Bauelement nach Anspruch 1 und 2,
dadurch gekennzeichnet,
daß zwischen Trägersubstrat (1) und der ersten Elektrode (3) eine Haftschicht (2) aus Ti, Cr, NiₓCr_{y} (0 ≤ x ≤ 1, 0 ≤ y ≤ 1) oderTiₓW_{y} (0 ≤ x ≤ 1, 0 ≤ y ≤ 1) aufgebracht ist.

4. Keramisches, passives Bauelement nach Anspruch 1 und 2,
dadurch gekennzeichnet,
daß wenigstens eine erste und zweite Stromzuführung an gegenüberliegenden Seiten des Bauelementes vorgesehen ist.

5. Keramisches, passives Bauelement nach Anspruch 1 und 2,
dadurch gekennzeichnet,
daß als Trägersubstrat (1) ein keramisches Material, ein glaskeramisches Material, ein Glasmaterial oder Silicium verwendet wird.

6. Keramisches, passives Bauelement nach Anspruch 1 und 2,
dadurch gekennzeichnet,
daß das Dielektrikum (5) Si₃N₄,
Ta₂O₅,
SiO₂,
SiₓN_{y}O_{z} (0 ≤ x ≤ 1, 0 ≤ y ≤ 1, 0 ≤ z ≤ 1),
SiO₂/Si₃N₄/SiO₂,
Ba_{1₋x}SrₓTiO₃ (0 ≤ x ≤ 1),
SrTi_{1₋x}ZrₓO₃ (0 ≤ x ≤ 1) mit und ohne Mn-Dotierungen,
BaO-Ln₂O₃-TiO₂ (Ln = La. Ce, Nd, Sm oder Eu)
Al₂O₃,
Ba₂Ti₉O₂₀,
Ba₂Ti_{9₋x}ZrₓO₂₀ (0 ≤ x ≤ 1) mit und ohne Mit-Dotierungen.
BaTi₅O₁₁,
BaTi₄O₉,
Nb₂O₅,
TiO₂,
(Ta₂O₅)ₓ-(Al₂O₃)_{1₋x} (0 ≤ x ≤ 1),
(Ta₂O₅)ₓ-(TiO₂)_{1₋x} (0 ≤ x ≤ 1),
(Ta₂O₅)ₓ-(Nb₂O₅)_{1₋x} (0 ≤ x ≤ 1),
(Ta₂O₅)ₓ-(SiO₂)_{1₋x} (0 ≤ x ≤ 1),
(Sr,Ca)(Ti,Zr)O₃,
BaO-SrO-CaO-Nd₂O₃-Gd₂O₃-Nb₂O₃-TiO₂,
CaSm₂Ti₅O₁₄,
Zr(Ti,Sn)O₄,
BaO-PbO-Nd₂O₃-Pr₂O₃-Bi₂O₃-TiO₂,
Ba(Zr,Zn,Ta)O₃,
CaTiO₃-LaAlO₃,
(Bi₃(Ni₂Nb)O₉)_{1₋x} (0 ≤ x ≤ 1),
(Bi₂(ZnNb_{2(1+d)y}O_{3+6y+5yd})ₓ (0 ≤ x ≤ 1, 0.5 ≤ y ≤ 1.5, -0.05 ≤ x ≤ 0.05),
Pb(ZrₓTi_{1₋x})O₃ (0 ≤ x ≤ 1) mit und ohne Bleiüberschuß,
Pb_{1₋αy}La_{y}(ZrₓTi_{1₋x})O₃ (0 ≤ x ≤ 1, 0 ≤ y ≤ 0.2, 1.3 ≤ α ≤ 1.5),
Pb_{1-αy} La_{y}TiO₃ (0 ≤ y ≤ 0.3, 1.3 ≤ α ≤ 1.5),
(Pb,Ca)TiO₃,
BaTiO₃ mir und ohne Dotierungen,
BaZrₓTi₁_{_{*-*}}ₓO₃ (0 ≤ x ≤ 1),
Ba_{1₋y}Sr_{y}ZrₓTi_{1₋x}O₃ (0 ≤ x ≤ 1, 0 ≤ y ≤ 1),
Ba(Zn,Ta)O₃,
BaZrO₃,
PbNbₓ((Zr_{0.6}Sn_{0.4})_{1₋y}Ti_{y}))_{1₋x}O₃ (0 ≤ x ≤ 0.9, 0 ≤ y ≤ 1),
Pb(Mg_{1/3}Nb_{2/3})O₃]ₓ-[PbTiO₃]_{1₋x} (0 ≤ x ≤ 1),
(Pb,Ba,Sr)(Mg_{1/3}Nb_{2/3})ₓTi_{y}(Zn_{1/3}Nb_{2/3})_{1₋x₋y}O₃ (0 ≤ x ≤ 1, 0 ≤ y ≤ 1, x + y ≤ 1),
a) Pb(Mg_{1/2}W_{1/2})O₃
b) Pb(Fe_{1/2}Nb_{1/2})O₃
c) Pb(Fe_{2/3} W_{1/3})O₃
d) Pb(Ni_{1/3}Nb_{2/3})O₃
e) Pb(Zn_{1/3}Nb_{2/3})O₃
f) Pb(Sc_{1/2}Ta_{1/2})O₃
sowie Kombinationen der Verbindungen a)- f) mit PbTiO₃ und Pb(Mg_{1/3}Nb_{2/3})O₃ mit und ohne Bleiüberschuß enthält.

7. Keramisches, passives Bauelement nach Anspruch 1 und 2,
dadurch gekennzeichnet,
daß die Elektroden (3, 7) Al, Al dotiert mit (Zu, Al dotiert mit Si, Al doriert mit Mg oder Ag, Cu, Ni, Au, W oder Kombinationen dieser Metalle enthalten.

8. Keramisches, passives Bauelement nach Anspruch 1 und 2,
dadurch gekennzeichnet,
daß auf der zweiten Elektrode (7) eine Schutzschicht (8) aus einem organischen und/oder anorganischen Polymer vorgesehen ist.
